(19) Europäisches Patentamt
European Patent Office
Office européen des brevets

(11) EP 4 511 664 B1

(12) FASCICULE DE BREVET EUROPEEN

(45) Date de publication et mention de la délivrance du brevet:
**17.06.2026 Bulletin 2026/25**

(21) Numéro de dépôt: **23725289.5**

(22) Date de dépôt: **20.04.2023**

(51) Classification Internationale des Brevets (IPC):
***G01R 31/379*** *(2019.01)* ***G01R 31/389*** *(2019.01)*
***G01R 31/392*** *(2019.01)* ***H02J 7/00*** *(2026.01)*

(52) Classification Coopérative des Brevets (CPC):
**H02J 7/875; G01R 31/379; H02J 7/84**

(86) Numéro de dépôt international:
**PCT/FR2023/050569**

(87) Numéro de publication internationale:
**WO 2023/203302 (26.10.2023 Gazette 2023/43)**

# (54) PROCÉDÉ DE DIAGNOSTIC POUR LA DÉTERMINATION D'UNE APTITUDE D'UNE BATTERIE PLOMB-ACIDE À ÊTRE RÉGÉNÉRÉE

DIAGNOSEVERFAHREN ZUR BESTIMMUNG DER REGENERATIONSFÄHIGKEIT EINER BLEISÄUREBATTERIE

DIAGNOSTIC METHOD FOR DETERMINING THE ABILITY OF A LEAD-ACID BATTERY TO BE REGENERATED

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **21.04.2022 FR 2203686**

(43) Date de publication de la demande:
**26.02.2025 Bulletin 2025/09**

(73) Titulaire: **Be Energy**
**84000 Avignon (FR)**

(72) Inventeurs:
- **COSTE, Bertrand**
  **30400 VILLENEUVE LES AVIGNON (FR)**
- **MOUNIER, Gilles**
  **30650 ROCHEFORT DU GARD (FR)**
- **FAVET, Thomas**
  **73800 MYANS (FR)**

(74) Mandataire: **Germain Maureau**
**12, rue Boileau**
**69006 Lyon (FR)**

(56) Documents cités:
**EP-A1- 2 506 024**
**US-A1- 2009 171 600**
**US-A1- 2017 331 162**
**US-B1- 6 259 254**
**US-B1- 6 369 577**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 4 511 664 B1

## Description

### [Domaine technique]

L'invention se rapporte à un procédé de diagnostic pour les batteries plomb-acide.

Elle se rapporte plus particulièrement à un procédé de diagnostic qui permet de déterminer, lorsqu'il est appliqué à une batterie plomb-acide, si cette dernière peut être régénérée ou si elle doit être recyclée.

L'invention trouve ainsi une application pour la détermination d'une aptitude à la régénération de tous types de batteries plomb-acide, par exemple les batteries de démarrage ou bien encore stationnaires.

### [Etat de la technique]

De manière connue, les batteries d'accumulateurs sont des systèmes consistant en un ensemble d'accumulateurs électriques qui sont reliés entre eux, et qui permettent, selon des réactions électrochimiques réversibles, de convertir et stocker l'énergie électrique sous forme chimique lors d'une phase dite de charge, et de la restituer sous forme de courant continu lors d'une phase dite de décharge. Une pluralité de types et de technologies de batteries sont disponibles dans l'existant. Les batteries plomb-acide sont utilisées dans de nombreux domaines (Automobile, Ferroviaire, Industriel, etc.), dans les réseaux et installations nécessitant l'accès immédiat à une énergie électrique en cas de coupure d'électricité comme les télécoms et les hôpitaux; ou bien encore sont au cœur de systèmes de production électrique en sites isolés non raccordés au réseau électrique (comme les installations solaires ou les sites d'éoliennes) en assurant le stockage et la redistribution de l'électricité jour et nuit.

Au cours de leur cycle de vie, les batteries sont amenées à effectuer à plusieurs reprises des charges et des décharges.

Plus précisément, les batteries (ou plus précisément les accumulateurs les constituant) comprennent deux électrodes positive et négative, capables toutes deux de capter ou céder des électrons et baignant dans un électrolyte. Lors d'une décharge, les réactions électrochimiques spontanées se produisant à l'électrode positive et négative permettent la génération d'un courant électrique continu. Les électrons se déplacent, en passant par un conducteur (un fil de métal par exemple) de l'électrode négative qui est le siège d'une réaction d'oxydation, à l'électrode positive qui est le siège d'une réaction de réduction. Dans le cas d'une batterie plomb-acide, constituée d'une électrode négative en plomb, d'une électrode positive en dioxyde de plomb et d'un électrolyte aqueux d'acide sulfurique, les demi-réactions en décharge sont les suivantes :

A l'électrode positive :

$$PbO_2 + HSO_4^- + 3H^+ + 2e^- \rightarrow PbSO_4 + 2H_2O$$

A l'électrode négative :

$$Pb + HSO_4^- \rightarrow PbSO_4 + H^+ + 2e^-$$

La réaction globale simplifiée est la suivante :

$$PbO_2 + Pb + 2H_2SO_4 \rightarrow 2PbSO_4 + 2H_2O$$

Cette réaction de double sulfatation (car du sulfate de plomb se forme à l'électrode positive et négative) a pour conséquence de consommer l'acide sulfurique présent dans l'électrolyte, et de produire de l'eau. Lorsqu'il y a décharge complète de la batterie, l'électrolyte sera composé uniquement d'eau distillée et les plaques seront sulfatées

Lors d'une charge, les réactions inverses se produisent. Dans l'exemple d'une batterie au plomb, les deux polarités se désulfatent, les électrodes sont alors chimiquement reconstituées et l'acidité de l'électrolyte est retrouvée. Cependant, au fil des charges et décharges, une accumulation d'une fiche couche cristalline de sulfate de plomb par un processus de dissolution / recristallisation est observable sur les électrodes, ce qui a pour effet de diminuer leur surface active et d'augmenter la résistance interne de la batterie. Cet amas de sulfate de plomb étant difficilement réversible lors de la phase de charge, il a pour conséquence de diminuer la capacité de la batterie (il est entendu par capacité l'énergie susceptible d'être emmagasinée et restituée par la batterie), jusqu'à ce que celle-ci soit mise au rebut.

En raison des enjeux écologiques actuels, de nombreuses solutions sont destinées au recyclage ou au réemploi

des déchets industriels. C'est le cas des batteries pour lesquelles sont proposées des systèmes et des procédés de régénération. Généralement, la régénération consiste à forcer la dissolution de ces amas de cristaux de sulfate de plomb au moyen de pulsation électriques de forte intensité à basse fréquence (quelques centaines de hertz). Si la batterie ne souffre pas principalement de sulfatation dure, et que d'autres mécanismes de dégradations entre en compte (court-circuit interne, corrosion etc..), la régénération ne sera pas efficace, et la batterie peut être amenée soit au recyclage, soit au rebut. En revanche, si la sulfatation dure est la cause principale du disfonctionnement de la batterie et de sa perte de capacité, alors le procédé de régénération par impulsion électrique permet d'amorcer la dissolution de ces amas de cristaux de sulfate de plomb, qui n'aurait pu être réalisé au moyen d'une charge classique sous courant constant. En conséquence, la capacité de la batterie est récupérée.

Préalablement à la mise en œuvre d'un procédé de régénération avec un système prévu à cet effet, l'aptitude d'une batterie plomb-acide à être régénérée est déterminée suite à un diagnostic consistant en une campagne d'au moins une mesure.

Plusieurs procédés de diagnostic pour évaluer l'aptitude d'une batterie à la régénération sont disponibles dans la littérature.

Le document US6259254 B1 divulgue un système de diagnostic mettant en œuvre un procédé de diagnostic pour lequel l'aptitude à la régénération de la batterie est évaluée notamment en calculant sa tension en circuit ouvert, et en mesurant et analysant certaines de ses caractéristiques au cours de l'application cycle de charge et de décharge.

Le document US6369577 B1 propose d'évaluer l'aptitude de la batterie à la régénération en calculant sa résistance interne dynamique.

Le document EP2947471 A1 divulgue quant à lui un procédé de diagnostic comprenant trois mesures permettant chacune d'évaluer l'aptitude d'une batterie à être régénérée selon l'état de ses électrodes, les trois mesures portant sur une évaluation de la corrosion des électrodes ; une mesure de la quantité de sulfate de plomb effective de l'électrolyte, et une mesure de la quantité d'oxyde de plomb effective de la matière active.

Toutefois, selon la nature des tests réalisés pour le diagnostic des batteries, les mesures, en plus d'être complexes à réaliser au point d'être rédhibitoires, peuvent ne pas être suffisamment précises. Egalement, elles peuvent ne pas être applicables/généralisables à tous les types de batterie plomb-acide. Par exemple, la mesure de l'état des électrodes d'une batterie plomb-acide et de la quantité de sulfate de plomb, comme proposé par EP2947471 A1, suppose un accès à l'intérieur de la batterie. Or, les batteries de démarrage plomb-acide souvent généralement scellées.

Enfin, certaines mesures sont difficilement applicables à de grands volumes de batteries, en raison du temps nécessaire pour implémenter les différentes mesures.

**[Résumé de l'invention]**

A cette fin, en vue de répondre aux problématiques mentionnées ci-dessus, l'invention propose un procédé de diagnostic pour évaluer une aptitude d'une batterie de type plomb-acide à être régénérée, lequel est :

- automatisé, l'opérateur n'ayant qu'à lancer à partir d'un système de diagnostic, auquel la batterie à diagnostiquer est reliée, le procédé de diagnostic pour évaluer si celle-ci est apte ou non à la régénération,
- simple à mettre en œuvre en ne nécessitant pas l'usage de dispositif de mesure devant accéder à l'intérieur de la batterie,
- rapide à exécuter, le système de diagnostic fournissant rapidement à l'opérateur après le lancement du procédé de diagnostic le résultat du diagnostic.
- généralisable aux batteries plomb-acide de démarrage ou stationnaires.

Le procédé de régénération est applicable à une batterie comme à un ensemble de batteries raccordées en parallèle.

L'invention proposée se présente ainsi comme un procédé de diagnostic pour évaluer une aptitude d'une batterie de type plomb-acide à être régénérée, ledit procédé de diagnostic étant exécuté par un système de diagnostic connecté électriquement à la batterie, et comprenant au moins :

- une première étape d'évaluation durant laquelle le système de diagnostic mesure une tension en circuit ouvert de la batterie puis la compare à une première valeur de seuil de tension ;
- une seconde étape d'évaluation mise en œuvre si la tension en circuit ouvert est supérieure à la première valeur de seuil de tension, et durant laquelle le système de diagnostic envoie à la batterie un courant de décharge durant une durée de décharge prédéterminée et mesure simultanément une variation de tension de la batterie durant la durée de décharge, dite variation de tension en décharge, ladite variation de tension en décharge étant comparée à une seconde valeur de seuil de tension ;

  et si la variation de tension en décharge est supérieure à la seconde valeur de seuil de tension, alors la batterie est

considérée comme inapte pour être régénérée ;

- une troisième étape d'évaluation mise en œuvre lorsque la variation de tension en décharge est inférieure à la seconde valeur de seuil de tension, durant laquelle le système de diagnostic identifie, au cours d'une sous-étape d'identification et à partir de la variation de tension en décharge, plusieurs paramètres électriques représentatifs de la batterie, qu'il compare ensuite, au cours d'une sous-étape de comparaison, respectivement à plusieurs paramètres électriques de seuil respectifs, le système de diagnostic établissant que la batterie est inapte pour être régénérée lorsque l'un des paramètres électriques parmi les plusieurs paramètres électriques n'est pas conforme au paramètre électrique de seuil qui lui est associé parmi les plusieurs paramètres électriques de seuil, et potentiellement apte à être régénérée autrement ; et
- une quatrième étape d'évaluation mise en œuvre si la batterie est considérée comme potentiellement apte à être régénérée suite à la troisième étape d'évaluation, durant laquelle le système de diagnostic envoie à la batterie un courant de charge durant une durée de charge prédéterminée et mesure simultanément une variation de tension de la batterie durant la durée de charge, dite variation de tension en charge, ladite variation de tension en charge étant comparée à une troisième valeur de seuil de tension ;

la batterie étant considérée comme apte à être régénérée si la variation de tension en charge est supérieure à la troisième valeur de seuil de tension.

Ainsi, le procédé de diagnostic proposé comprend au moins quatre étapes d'évaluation permettant de déterminer rapidement si une batterie est potentiellement apte à être régénérée ou non.

La première étape d'évaluation consiste en une mesure de tension en circuit ouvert pour évaluer l'état de charge en première estimation: plus la tension en circuit ouvert mesurée est élevée, plus la batterie est chargée. Inversement, plus la tension en circuit ouvert est faible, plus la batterie est déchargée. La tension en circuit ouvert de la batterie est comparée à une première valeur de seuil de tension telle que si elle est inférieure à ladite première valeur de seuil de tension, alors cela signifie que la batterie n'est pas apte à être régénérée, ou du moins que même en lui appliquant un procédé de régénération de batterie, le gain en capacité ne sera pas suffisant pour un fonctionnement correct/nominal.

La seconde étape d'évaluation consiste à envoyer sur la batterie un courant de décharge durant une durée de décharge prédéterminée et mesurer simultanément une variation de tension en décharge de la batterie qui correspond à une chute de tension, laquelle est comparée à une seconde valeur de tension de seuil.

L'objectif de cette mesure est de vérifier rapidement l'état de la batterie et/ou de déterminer la valeur de la tension nominale de la batterie, qui correspond à la valeur moyenne de la chute de tension et celle pour laquelle la batterie est considérée comme fonctionnant correctement/normalement. Une chute de tension trop importante, supérieure à la seconde valeur de seuil de tension, traduit un état de dégradation très/trop avancé (pouvant être dû à la sulfatation des électrodes, la corrosion, la dégradation du contact électrode/collecteur de courant, etc.) impliquant qu'il serait impossible de régénérer la batterie quelle que soit l'intensité du courant de charge appliqué en vue de la régénérer. Dans ce cas, la batterie est diagnostiquée comme inapte à la régénération.

Avantageusement, cette seconde étape permet un gain de temps en évitant à l'opérateur d'appliquer à la batterie défectueuse un procédé de régénération.

Si la batterie est diagnostiquée à la fin de la seconde étape d'évaluation comme potentiellement apte à être régénérée, le procédé de diagnostic comprend une troisième étape d'évaluation faisant suite à la seconde étape d'évaluation qui permet, avantageusement, à partir de la variation de tension en décharge observée, de déterminer plus précisément l'état de la batterie et, dans le cas où elle serait dégradée, les cause de ces dégradations.

La première valeur de seuil et la seconde valeur de seuil dépendent du type de batterie qui est diagnostiquée et de ses caractéristiques : batterie de démarrage ou batterie stationnaire, tension nominale et capacité.

Plus précisément, la troisième étape d'évaluation consiste dans un premier temps, lors d'une sous-étape d'identification, à identifier et estimer la valeur de plusieurs paramètres électriques représentatifs de l'état de la batterie, en vue notamment de :

- déterminer sa résistance interne : plus la résistance d'une batterie est élevée, plus la capacité de la batterie est faible. Les causes de l'augmentation de la résistance interne de la batterie sont nombreuses. Elle peut être due à la sulfatation des électrodes, à la corrosion, à la dégradation du contact électrode/collecteur de courant, etc.
- déterminer la résistance de la batterie à des fortes variations de température, et notamment établir si elle présente un risque important de surchauffe.
- déterminer les cause précises de la chute de tension qui peut être due à trois types de polarisations : une polarisation ohmique (ou chute ohmique) liée aux résistances des électrodes et des contacts des différents composants de la batterie ; une polarisation d'activation à l'interface électrode/électrolyte provoquée par le processus de transfert de charge dans l'électrolyte d'acide sulfurique entre les deux électrodes ; et une polarisation de concentration provoquée par la production d'eau distillée dans l'électrolyte lors des réactions de charge/décharge, et la cinétique de diffusion des espèces dans l'électrolyte.

Les valeurs relevées pour chacun des paramètres électriques sont ensuite comparées, lors d'une sous-étape de comparaison, à des valeurs de seuil représentatives d'une batterie non dégradée et pour laquelle la profondeur de décharge reste suffisamment faible pour permettre un fonctionnement nominal/correct de la batterie dans le cas où elle serait à nouveau chargée, soit un pourcentage de profondeur de décharge peu élevé. Par profondeur de décharge, il est entendu le pourcentage d'une batterie déchargée par rapport à sa capacité totale.

Si les valeurs de chacun des paramètres électriques sont conformes/en adéquation avec leurs valeurs de seuil respectives, alors la batterie testée est diagnostiquée comme étant potentiellement apte à être régénérée. Il est entendu, dans le cadre de la présente invention, qu'un paramètre électrique est conforme au paramètre électrique de seuil qui lui associé, lorsque la valeur de ce paramètre électrique est équivalente à ce paramètre électrique de seuil, à plus moins 15% près, et par exemple à plus ou moins 10% près.

Par contre, si l'une au moins des valeurs de chacun des paramètres électriques n'est pas conforme à la valeur de seuil associée, alors la batterie testée est diagnostiquée comme étant non régénérable.

Les valeurs des paramètres électriques de seuil dépendent du type de batterie qui est diagnostiquée et de ses caractéristiques : batterie de démarrage ou batterie stationnaire, tension nominale et capacité.

Le procédé de diagnostic comprend enfin une quatrième et dernière étape d'évaluation faisant suite à la troisième étape d'évaluation si, en conclusion de cette dernière, la batterie a été diagnostiquée comme étant potentiellement apte à être régénérée. Cette quatrième étape d'évaluation consiste à envoyer aux bornes de la batterie un courant de charge durant une durée de charge prédéterminée et mesurer simultanément une variation de tension en charge correspondant à une élévation de la tension.

La troisième valeur de seuil et le courant de charge dépendent du type de batterie qui est diagnostiquée et de ses caractéristiques : batterie de démarrage ou batterie stationnaire, tension nominale et capacité.

La quatrième étape d'évaluation, en combinaison avec la seconde étape d'évaluation, met en œuvre un cycle de charge/décharge complet.

La variation de tension en charge, qui correspond à une élévation de tension, est comparée à une troisième valeur de seuil de tension. Si cette élévation est supérieure à ladite troisième valeur de seuil de tension, cela signifie que la batterie est apte à être régénérée ; et inapte à la régénération autrement car malgré la charge, la capacité de la batterie reste insuffisante pour un fonctionnement correct/nominal de la batterie et qu'elle ne peut pas être régénérée.

Avantageusement, le procédé de diagnostic complet est rapide à mettre en œuvre. En effet, la réalisation successive des quatre étapes d'évaluation peut durer seulement 10 secondes environ.

Selon une caractéristique de l'invention, les plusieurs paramètres électriques sont identifiés durant la sous-étape d'identification en corrélant la variation de tension en décharge à une tension de sortie d'un modèle électrique équivalent modélisé dans le système de diagnostic et représentatif de la batterie, lequel modèle électrique équivalent étant simulé avec le courant de décharge durant une durée de simulation égale à la durée de décharge.

Il est à noter que ces valeurs des paramètres électriques représentatifs des phénomènes mentionnés ci-avant causant la variation de tension en décharge (la chute de tension) de la batterie sont déterminées sans devoir accéder au contenu de la batterie. En effet, le système de diagnostic met en œuvre un modèle électrique équivalent permettant de simuler une tension de sortie de la batterie sous l'effet du courant de décharge et des phénomènes susmentionnés. Le système de diagnostic simule le modèle électrique équivalent pour une durée de simulation égale à la durée de décharge. Le système de diagnostic compare ensuite la variation de tension en décharge avec la tension de sortie du modèle électrique dans une simulation équivalente. In fine, le système de diagnostic identifie les valeurs de chacun des paramètres électriques lorsqu'il parvient à corréler la tension de sortie avec la variation de tension en décharge.

Selon une caractéristiques de l'invention, les plusieurs paramètres électriques comprennent une résistance de chute ohmique, une résistance de transfert de charge, une résistance de diffusion, une capacitance de transfert de charge, et une capacitance de diffusion ; et les plusieurs paramètres électriques de seuil comprennent une résistance de chute ohmique de seuil, une résistance de transfert de charge de seuil, une résistance de diffusion de seuil, une capacitance de transfert de charge de seuil, et une capacitance de diffusion de seuil.

Autrement dit, les paramètres électriques identifiés au cours de la sous-étape d'identification correspondent à :

- une résistance de chute ohmique, relative au phénomène de chute ohmique, soit à la polarisation ohmique ;
- une résistance de transfert de charge et une capacitance de transfert de charge, relatives aux phénomène de transfert de charge, c'est-à-dire les électrons, à l'interface électrode/électrolyte, soit à la polarisation de transfert ;
- une résistance de diffusion et une capacitance de diffusion, relatives aux phénomène de diffusion des espèces dans l'électrolyte, soit à la polarisation de concentration ; chacun de ces paramètres électriques (plus précisément, leurs valeurs) étant donc, au cours de la sous-étape de comparaison, comparé à un paramètre électrique de seuil associé (plus précisément, à une valeur de seuil).

Selon un mode de réalisation de l'invention, le modèle électrique équivalent comprend un générateur d'entrée délivrant une tension d'entrée correspondant à la tension en circuit ouvert, ainsi que plusieurs paramètres électriques

équivalents incluant une résistance de diffusion équivalente, une capacitance de diffusion équivalente, une résistance de transfert de charge équivalente, une capacitance de transfert de charge équivalente, et une résistance de chute ohmique équivalente tels que :

- un premier bloc, comprenant la résistance de diffusion équivalente mise en parallèle avec la capacitance de diffusion équivalente, est mis en série en sortie du générateur d'entrée,
- un second bloc, comprenant la résistance de transfert de charge équivalente mise en parallèle avec la capacitance de transfert de charge équivalente, est mis en série en sortie du premier bloc, et
- la résistance de chute ohmique équivalente est mise en série en sortie du second bloc.

Selon une caractéristique de l'invention, lors de la sous-étape d'identification, est mise en œuvre une analyse paramétrique en faisant varier les paramètres électriques équivalents jusqu'à corréler substantiellement la tension de sortie du modèle électrique équivalent avec la variation de tension en décharge, et en déduire une valeur de chacun des plusieurs paramètres électriques comme étant équivalente au paramètre électrique équivalent qui lui est associé.

Autrement dit, le modèle électrique équivalent permet de simuler, pendant un temps de simulation correspondant à la durée de décharge, la chute de tension de la batterie lorsqu'un courant de décharge lui est appliqué, en tenant compte également des phénomènes de chute ohmique, de diffusion, et de transfert de charge qui sont respectivement modélisés par la résistance de chute ohmique équivalente, la résistance de diffusion équivalente et la capacitance de diffusion équivalente, et la résistance de transfert de charge équivalente et la capacitance de transfert de charge équivalente.

Le système de diagnostic détermine les valeurs des paramètres électriques en lançant une analyse paramétrique, c'est-à-dire en exécutant plusieurs simulations successives de la tension de sortie du modèle électrique équivalent pour lesquelles sont considérées différentes valeurs de paramétriques électriques équivalents ; les différentes valeurs de chacun des paramètres électriques équivalent étant comprises dans des plages de valeur définies par exemple chacune selon une valeur de départ, une valeur d'arrivée, et un pas d'incrémentation.

Lorsque le système de diagnostic parvient à corréler la chute de tension de la batterie mesurée, c'est-à-dire variation de tension en décharge, avec la chute de tension simulée, c'est-à-dire la tension de sortie du modèle électrique équivalent, cela signifie que les valeurs des paramètres électriques équivalents sont égales aux valeurs des paramètres électriques qui sont désormais connues.

Avantageusement, au moyen du modèle électrique équivalent, la troisième étape d'évaluation est entièrement automatisée, généralisable à tous types de batteries, et ne nécessitent pas d'accéder à l'intérieur de la batterie et de procéder à des mesures sur les électrodes et l'électrolyte pour déterminer les valeurs des paramètres électriques, d'où son adéquation avec le procédé de diagnostic.

Selon une caractéristique de l'invention, la troisième valeur de seuil de tension est inférieure ou égale à 500 mV, et par exemple inférieure ou égale à 300 mV.

Selon une caractéristique de l'invention, le courant de charge est un courant de charge continu ayant une intensité à 2A, à plus ou moins 10 %, et la durée de charge est comprise entre 1 et 10 secondes.

Selon une caractéristique de l'invention, la première valeur de seuil de tension est égale à 10,8 V, à plus ou moins 10% près, et la seconde valeur de seuil de tension est égale à 1V, à plus ou moins 10% près.

Autrement dit, les premières et secondes valeurs de seuil de tension ne sont pas des valeurs figées, dans le sens où, et comme expliqué précédemment, elles dépendent des caractéristiques de la batterie et du type de la batterie entre une batterie de démarrage et une batterie stationnaire.

Selon une caractéristique de l'invention, le courant de décharge est un courant de décharge continu ayant une intensité égale à 2A, à plus ou moins 10 % près, et la durée de décharge est comprise entre 1 et 10 secondes.

Selon une caractéristique de l'invention, le système de diagnostic est connecté électriquement à la batterie au moyen d'une première pince reliée à un pôle positif et une seconde pince reliée à un pôle négatif de ladite batterie.

Avantageusement, le procédé de diagnostic est très facilement mis en œuvre car il suffit de raccorder électriquement le système de diagnostic à la batterie à diagnostiquer. En l'occurrence, le raccordement se fait en connectant le système de diagnostic au moyen de deux pinces aux bornes positive et négative de la batterie.

Selon une caractéristique de l'invention, le système de diagnostic est connecté à ou comprend au moins un dispositif de mesure de tension pour mesurer au moins la tension en circuit ouvert et la variation de tension en décharge.

Selon une variante de réalisation de l'invention de l'invention, le système de diagnostic est connecté à ou comprend un dispositif de mesure de température conformé pour mesurer une température de la batterie au moins au cours de la première étape d'évaluation et de la seconde étape d'évaluation.

La température influe sur la vitesse des réactions électrochimiques se produisant au niveau des interfaces électrodes/électrolyte de la batterie. Si la température baisse, la vitesse de réaction diminue. En supposant que la tension de la batterie reste constante, le courant de décharge diminue, ainsi que la puissance restituable de la batterie. Inversement, si la température augmente, la vitesse des réactions électrochimiques augmente et donc la puissance

restituable de la batterie. Par conséquent, les performances de la batterie durant les phases de charge et de décharge de la batterie dépendent de la température. Plus précisément, durant la phase de décharge, la température influe sur les phénomènes de chute ohmique, de diffusion et bien entendu de transfert de charge.

C'est pourquoi, dans une variante de réalisation de l'invention, le système de diagnostic peut comprendre ou être connecté à un dispositif de mesure conforme pour mesure la température de la batterie au moins durant la première étape et la seconde étape d'évaluation. Par extension, dans d'autres modes de réalisation, ce dispositif de mesure de température est utilisé durant la quatrième étape d'évaluation.

En fonction de la température relevée par le dispositif de mesure, le système de diagnostic adapte l'une au moins des première, seconde, et troisième valeurs de seuil de tension.

L'invention se rapporte également à un système de diagnostic pour évaluer une aptitude d'une batterie de type plomb-acide à être régénérée, ledit système de diagnostic comprenant une unité de contrôle conformée pour la mise en œuvre des étapes d'évaluation du procédé de diagnostic décrites auparavant.

## [Brève description des figures]

D'autres caractéristiques et avantages de la présente invention apparaîtront à la lecture de la description détaillée ci-après, d'un exemple de mise en œuvre non limitatif, faite en référence aux figures annexées dans lesquelles :

[Fig 1] montre le logigramme du procédé de diagnostic de la présente invention tel que considéré dans le mode de réalisation préférentiel, pour lequel sont incluses dans le procédé de diagnostic les quatre étapes d'évaluation ; les termes « APTE » et « INAPTE » indique respectivement quand le procédé de diagnostic conclut que la batterie est apte ou inapte à être régénérée ;

[Fig 2] est une vue schématique de l'invention dans son mode de réalisation préférentiel, pour lequel la batterie est connectée au système de diagnostic à l'aide de pinces, avec un dispositif de mesure de tension branché en parallèle à la batterie et mesurant la tension de celle-ci ;

[Fig 3] est une courbe illustrant deux exemples de variation de tension en décharge / chute de tension pour deux batteries différentes obtenues durant la seconde étape d'évaluation du procédé de diagnostic, tels qu'une des batteries soit potentiellement apte à être régénérée, la variation de tension en décharge observée à ses bornes étant inférieure à la seconde valeur de seuil de tension, et l'autre ne peut pas être régénérée, variation de tension en décharge observée à ses bornes étant supérieure à la seconde valeur de seuil de tension ;

[Fig 4] correspond au modèle électrique équivalent utilisé durant la sous-étape d'identification de la troisième étape d'évaluation du procédé de diagnostic pour la détermination des paramètres électriques caractérisant la batterie ;

[Fig 5] est une courbe illustrant un exemple de variation de tension en charge d'une batterie obtenue au cours de la quatrième et dernière étape d'évaluation du procédé de diagnostic.

## [Description détaillée d'un ou plusieurs modes de réalisation de l'invention]

En référence aux figures 1 et 2, le procédé de diagnostic P pour diagnostiquer l'aptitude d'une batterie 2 à être régénérée est exécuté par le système de diagnostic 1 qui est relié électriquement au pôle positif 21 et au pôle négatif 22 de ladite batterie 2 au moyen d'une première pince 111 et d'une seconde pince 112. Il est également possible avec l'invention de diagnostiquer l'aptitude à la régénération d'un ensemble de plusieurs batteries 2 raccordées électriquement en parallèle. Dans ce cas, la première pince 111 et la seconde pince 112 sont connectées au pôle positif 21 et au pôle négatif 22 de l'une des plusieurs batteries 2.

Plus précisément, le procédé de diagnostic est lancé depuis un logiciel 14 installé dans une unité de contrôle 11 comprise dans le système de diagnostic 1. L'unité de contrôle comprend également :

- une unité d'affichage 12, tel qu'un écran pour afficher par exemple : la référence de la batterie en cours de diagnostic ; les paramètres de configuration des étapes d'évaluation E1, E2, E3 et E4 ; le déroulement de ces dites étapes d'évaluation E1, E2, E3, E4, comme les réponses en tension de la batterie 2 lorsque lui sont envoyés respectivement les courants de décharge Id et de charge Ic au cours respectivement de la seconde étape d'évaluation E2 et de la quatrième étape d'évaluation E4 ; le résultat du diagnostic : dans le mode de réalisation préférentiel de l'invention, l'unité d'affichage 12 affiche un « APTE » pour indiquer que la batterie est apte à la régénération, un « INAPTE » autrement ; etc.
- une unité de réglage 13, comprenant un clavier, et/ou un pavé tactile, et/ou des boutons, pour configurer/paramétrer les étapes d'évaluation E1, E2, E3, E4, par exemple : définir l'intensité des courants de décharge Id et de charge Ic et les durées de décharge td et de charge tc respectivement pour seconde étape d'évaluation E2 et de la quatrième étape d'évaluation E4 ; définir les valeurs de seuil de tension Vt1, Vt2, Vt3 utilisées respectivement durant la première étape d'évaluation E1, la seconde étapes d'évaluation E2 et la quatrième étape d'évaluation E4 ; les valeurs des

paramètres électriques représentatif de la batterie ; etc.

Dans le mode de réalisation préférentiel de l'invention, l'unité de contrôle 11 est un ordinateur (de bureau ou portable).

Selon différents modes de réalisation de l'invention, l'ensemble des paramètres servant à configurer les étapes d'évaluation E1, E2, E3, E4 ; à définir les valeurs de seuil de tension Vt1, Vt2, Vt3 ainsi que les courants de décharge Id et de charge Ic... peut être entrer manuellement par l'opérateur avant le lancement du procédé de diagnostic P ; ou bien être automatiquement fourni en chargeant des configurations de diagnostic que l'opérateur aura préalablement enregistré dans le logiciel 14, par exemple une configuration de diagnostique typique d'une batterie de démarrage, une adaptée aux batteries stationnaires, etc.

Le système de diagnostic comprend également un générateur de courant 10 dont la borne positive 101 délivre au pôle positif 21 de la batterie 2, au moyen de la première pince 111, les courants de décharge Id et de charge Ic ; la seconde pince 112, connectée au pôle négatif 22 de la batterie 2, étant reliée à la borne négative 102 du générateur de courant 10 qui fait office de masse. Le générateur de courant 10 est piloté au moyen de l'unité de contrôle 11 et est conformé pour fournir les intensités des courants de décharge Id et de charge Ic durant respectivement les temps de décharge td et de charge tc tels que paramétrées par l'opérateur.

Un dispositif de mesure de tension 3 est connecté parallèlement à la batterie pour mesurer en temps réel une tension aux bornes de la batterie 2. Il est ainsi utilisé pour mesurer, selon la description fournie précédemment, la tension en circuit ouvert VCO durant la première étape d'évaluation E1, la tension de décharge Vd et donc la variation de tension en décharge $\Delta Vd$ durant la seconde étape d'évaluation E2, et la tension de charge Vc et donc la variation de tension en charge $\Delta Vc$ durant la quatrième étape d'évaluation E4, Le dispositif de mesure communique avec l'unité de contrôle en lui envoyant en temps réel la tension mesurée. Selon un mode de réalisation de l'invention, le dispositif de mesure de tension peut être un système de contrôle de batterie.

La première étape d'évaluation E1 et la seconde étape d'évaluation E2 permettent, en première estimation, d'évaluer l'état de charge d'une batterie 2 et d'identifier en fin de diagnostic les batteries 2 pour lesquelles la dégradation est certaine, évitant ainsi à l'opérateur de perdre du temps à appliquer un procédé de régénération.

Le procédé de diagnostic P comprend, en étape d'évaluation supplémentaire, la troisième étape d'évaluation E3, qui permet de déterminer avec davantage de précision si une batterie est potentiellement apte à la régénération ou si elle n'est pas régénérable.

En résumé, le procédé de diagnostic P inclut l'ensemble des étapes d'évaluation E1, E2, E3 et E4, et permet de déterminer avec précision et exactitude si une batterie est apte ou non à la régénération.

L'opérateur paramètre au moyen de l'unité de réglage 13 l'ensemble des étapes d'évaluation incluses dans le procédé de diagnostic P avant exécution de celui-ci par l'unité de contrôle 11. Une fois que l'opérateur lance l'exécution du procédé de diagnostic P, l'unité de contrôle 11 met en œuvre automatiquement chacune des étapes d'évaluation sans qu'il ait besoin d'intervenir. L'opérateur n'a donc qu'à attendre que le système de diagnostic 1 lui fournisse le résultat du diagnostic : batterie 2 apte à la régénération, « APTE » ; batterie non apte à la régénération, « INAPTE ».

Comme précédemment indiqué, la première étape d'évaluation E1 consiste en une mesure de tension en circuit ouvert VCO de la batterie 2, laquelle tension en circuit ouvert VCO est comparée à une première valeur de seuil de tension Vt1 égale à 10,8 V à plus ou moins 10% près. La première valeur de seuil de tension est notamment définie en fonction du type de batterie à diagnostiquer, c'est-à-dire s'il s'agit d'une batterie de démarrage ou d'une batterie stationnaire.

Dans la tension en circuit ouvert VCO est inférieure à la première valeur de seuil de tension Vt1, le procédé de diagnostic P est arrêté. L'unité d'affichage 12 indique à l'opérateur que la tension de la batterie (et donc son état de charge) est trop faible pour réaliser un diagnostic, et affiche un « INAPTE ». En fonction de la valeur de la tension en circuit ouvert VCO mesurée, le logiciel 14, par l'intermédiaire de l'unité d'affichage 12, peut suggérer à l'opérateur de réaliser une charge de réveil.

Ainsi, le diagnostic de la batterie peut comprendre une étape intermédiaire de réveil, qui n'est toutefois pas couverte par l'invention, qu'il s'agisse du procédé de diagnostic P ou du système de diagnostic 1. Avec un autre dispositif de charge non compris dans l'invention, l'opérateur va appliquer un courant de charge de réveil à la batterie 2. Ce courant de charge de réveil a pour effet de charger la batterie 2 et d'augmenter sa capacité. L'opérateur peut ensuite réappliquer à la batterie 2 « réveillée » le procédé de diagnostic P, qui va redémarrer à la première étape d'évaluation E1. Si la nouvelle tension en circuit ouvert VCO mesurée reste inférieure à la première valeur de tension de seuil Vt1, alors l'opérateur peut définitivement conclure que la profondeur de décharge de la batterie 2 est trop importante pour pourvoir être régénérée.

Dans le cas où la tension en circuit ouvert VCO est supérieure à la première valeur de seuil de tension Vt1, le procédé de diagnostic P passe à la seconde étape d'évaluation E2.

La seconde étape d'évaluation E2 consiste, au moyen du générateur de courant 10, à envoyer un courant de décharge Id à la batterie 2 pendant une durée de décharge td et d'observer sa variation de tension en décharge $\Delta Vd$, qui correspond à une chute de tension sur la durée de décharge td entre le début et la fin, en réponse au dit courant de décharge Id ; l'objectif de la seconde étape d'évaluation E2 étant d'établir rapidement l'état de la batterie 2 et/ou de

déterminer la valeur de sa tension nominale, qui correspond à la valeur moyenne de la chute de tension et celle pour laquelle la batterie est considérée comme fonctionnant correctement/normalement.

Le courant de décharge Id est un courant continu ayant une intensité égale à 2A, à plus ou moins 10% près. L'intensité dépend du type de batterie 2 testé. La durée de décharge td est quant à elle comprise entre 1 et 10 secondes. Pour une batterie de démarrage standard, la durée de décharge td est en moyenne égale à 2,5 secondes.

En référence à la Figure 3, deux exemples de variation de tension en décharge $\Delta Vd$ en fonction du temps de décharge td sont illustrés pour deux batteries 2 distinctes. A noter que les variations de tension en décharge $\Delta Vd$ sont tracées sur le même graphique qu'à des fins Illustratives. Concrètement, les deux batteries 2 sont testées de manière indépendantes et l'une à la suite de l'autre, avec deux exécutions successives du procédé de diagnostic P. L'unité d'affichage 12 n'affiche donc que la variation de tension en décharge $\Delta Vd$ correspondant à la batterie en cours de diagnostic.

Soit $\Delta Vd1$ et VCO1 respectivement la variation de tension en décharge et la tension en circuit ouvert (à td = 0, quand le courant de décharge Id n'est pas encore appliqué) de la première batterie, et $\Delta Vd2$ et VCO2 respectivement la variation de tension en décharge et la tension en circuit ouvert de la première batterie. Pour la première batterie, la variation de tension en décharge $\Delta Vd1$ est peu importante, avec une valeur moyenne de tension assez proche de la tension en circuit ouvert VCO1. La variation de tension en décharge $\Delta Vd2$ est en revanche plus significative pour la seconde batterie.

Chacune des variations de tension en décharge $\Delta Vd1$, $\Delta Vd2$ est comparée à une seconde valeur de seuil de tension Vt2,

Pour qu'une batterie 2 soit considérée comme potentiellement régénérable, la variation de tension en décharge $\Delta Vd$ doit être inférieure à la seconde valeur de seuil de tension Vt2. Il est considéré dans l'exemple que $\Delta Vd1 < Vt2 < \Delta Vd2$. Ainsi, dans le cas de la première batterie, l'unité de contrôle 11 poursuit alors l'exécution du procédé de diagnostic P en initiant la troisième étape d'évaluation E3. Pour la seconde batterie, le procédé de diagnostic P est arrêté, avec l'unité d'affichage 12 affichant un « INAPTE ».

La seconde valeur de seuil de tension Vt2 est égale à 1 V à plus ou moins 10% près, et dépend notamment du type de batterie 2 diagnostiquée (batterie de démarrage ou batterie stationnaire).

Afin de déterminer avec davantage de précision l'état de la batterie 2 et si est potentiellement apte à la régénération ou non, les phénomènes causant la chute de tension, c'est-à-dire les polarisations de chute ohmique, d'activation et de concentration, sont quantifiés au cours de la troisième étape dévaluation E3 avec la détermination des valeurs des paramètres électriques représentatif de ces phénomènes, c'est-à-dire : la résistance de chute ohmique R0 représentative de la polarisation ohmique, la résistance de transfert de charge R1 et la capacitance de transfert de charge C1 associées à la polarisation d'activation, et la résistance de diffusion R2 et la capacitance de diffusion C2 associées à la polarisation de concentration. La connaissance de ces paramètres électriques permet notamment, comme mentionné auparavant, de déterminer la résistance interne de la batterie, d'estimer le degré de sulfatation des électrodes, la concentration d'eau distillée dans l'électrolyte.

Les valeurs des paramètres électriques sont déterminées durant une sous-étape d'identification comprise dans la troisième étape d'évaluation, en corrélant la variation de tension en décharge $\Delta Vd$ à une tension de sortie VO d'un modèle électrique équivalent 20 compris dans le logiciel 14 et représentatif de la batterie, lequel modèle électrique équivalent 20 est simulé durant une durée de simulation égale à la durée de décharge td.

Le modèle électrique équivalent 20 est illustré Figure 4. Il comprend un générateur d'entrée G délivrant une tension d'entrée correspondant à la tension en circuit ouvert VCO, ainsi que plusieurs paramètres électriques équivalents incluant une résistance de diffusion équivalente R2eq, une capacitance de diffusion équivalente C2eq, une résistance de transfert de charge équivalente R1eq, une capacitance de transfert de charge équivalente C1eq, et une résistance de chute ohmique équivalente R0eq tels que :

- les effets de la polarisation de concentration sont modélisés au travers d'un premier comprenant la résistance de diffusion équivalente R2eq mise en parallèle avec la capacitance de diffusion équivalente C2eq, le premier bloc est mis en série en sortie du générateur d'entrée G,
- les effets de la polarisation d'activation sont modélisés au travers d'un second bloc, comprenant la résistance de transfert de charge équivalente R1eq mise en parallèle avec la capacitance de transfert de charge équivalente C1eq, le second bloc étant mis en série en sortie du premier bloc, et
- les effets de la polarisation ohmique sont modélisés au travers de la résistance de chute ohmique équivalente R0eq qui est mise en série en sortie du second bloc.

Ainsi, la tension de sortie VO, qui correspond à une chute de tension aux bornes d'une batterie 2 suite à l'application d'un courant de décharge Id pendant un temps de décharge td, et pour laquelle sont pris en compte l'ensemble des phénomènes de polarisation, s'exprime selon l'équation suivante :

$$VO(t)=VCO-R0eq.Id(t)-R1eq.Id(t).\left(1-e^{-\frac{t}{R1eq.C1eq}}\right)-R2eq.Id(t).\left(1-e^{-\frac{t}{R2eq.C2eq}}\right)$$

où t est le temps en seconde ; R0eq, R1eq et R2eq sont exprimées en Ohm ; et Cleq et C2eq sont exprimées en Farad.

Ainsi, plusieurs allures de tension de sortie VO sont possibles en simulant le modèle électrique pour plusieurs jeux de valeur de paramètre électriques équivalent. Lorsque la tension de sortie VO est substantiellement corrélée avec la variation de tension en décharge ΔVd, cela signifie que chacun des paramètres électriques équivalent est substantiellement égal au paramètre électrique qui lui est associé (c'est-à-dire : R0eq ≈ R0, R1eq ≈ R1, etc.).

La corrélation est obtenue suite à une analyse paramétrique exécutée par le logiciel 14 durant laquelle, au cours de plusieurs itérations de simulation successives, celui-ci fait varier les valeurs des paramètres électriques équivalents jusqu'à ce que l'écart entre tension de sortie VO et la variation de tension en décharge ΔVd soit le plus négligeable possible. Il est entendu que pour procéder à l'analyse paramétrique, le logiciel 14 enregistre toutes les valeurs de variation de tension en décharge ΔVd mesurées pendant la durée de décharge td au cours de la seconde étape d'évaluation E2.

Dans le mode de réalisation préférentiel de l'invention, le logiciel 14 applique la méthode des moindres carrés pour corréler les deux tensions et déterminer les valeurs des paramètres électriques.

Suite à la sous-étape d'identification, le procédé de diagnostic compare, dans une sous-étape de comparaison, chacun des paramètres électriques à un paramètre électrique de seuil, soit : une résistance de chute ohmique de seuil (R0t), une résistance de transfert de charge de seuil (R1t), une résistance de diffusion de seuil (R2t), une capacitance de transfert de charge de seuil (C1t), et une capacitance de diffusion de seuil (C2t).

A la fin de cette troisième étape d'évaluation E3, la batterie 2 est considérée comme potentiellement régénérable lorsque tous les paramètres électriques sont conformes aux paramètres électriques de seuil ; et non régénérable si l'au moins un des paramètres électriques n'est pas conforme comparativement à son paramètre électrique de seuil associé. Dans le premier cas, le procédé de diagnostic P se poursuit avec la quatrième étape d'évaluation E4. Dans le second cas, il est stoppé et l'unité d'affichage 12 affiche un « INAPTE ».

La quatrième étape d'évaluation E4 permet de diagnostiquer si la batterie 2 est apte à la régénération ou non. Elle consiste à envoyer aux bornes de la batterie 2 au moyen du générateur de courant 10 un courant de charge Ic continu durant une durée de charge tc, et mesurer simultanément une variation de tension en charge ΔVc correspondant à une élévation de tension sur la durée de charge tc entre le début et la fin, telle qu'illustrée Figure 5. En combinaison avec la seconde étape d'évaluation E2, la quatrième étape d'évaluation E4 permet de réaliser un charge/décharge complet de la batterie 2, qui permet d'évaluer précisément la capacité de la batterie, ainsi que son état de santé qui correspond au ratio entre sa capacité nominale et sa capacité mesurée à l'instant et est représentatif de son vieillissement.

Le courant de charge Ic est appliqué à la batterie 2 pour une intensité de 2A, à plus ou moins 10%, et dépend du type de batterie 2 diagnostiquée. La durée de décharge est quant à elle comprise entre 1 et 10 secondes. Pour une batterie de démarrage standard, la durée de décharge td est en moyenne égale à 2,5 secondes.

La variation de tension en charge ΔVc est comparée à une troisième valeur de seuil de tension Vt3 non nulle et pouvant être inférieure ou égale à 500 mV selon le type de batterie testé (pour une batterie de démarrage, la troisième valeur de seuil de tension Vt3 est généralement en moyenne égale à 250 mV). La batterie 2 testée est apte à être régénérée si la variation de tension en charge ΔVc est supérieure à Vt3, et inapte si elle reste inférieure à ce seuil de tension. Le logiciel 14 arrête le procédé de diagnostic P dans les deux, ce dernier étant arrivé au bout de son exécution. Si a batterie 2 est apte à la régénération, l'unité d'affichage affiche un « APTE », sinon un « INAPTE ».

Dans des variantes de réalisation de l'invention, la température de la batterie peut être prise en compte. En effet, comme précédemment expliqué, les variations de température influent sur la vitesse des réactions électrochimiques se produisant au niveau des interfaces électrodes/électrolyte de la batterie 2 et donc sur sa puissance. Par conséquent, les performances de la batterie durant les phases de charge et de décharge de la batterie dépendent de la température. Plus précisément, durant la phase de décharge, la température influe sur les trois phénomènes de polarisation.

Pour ces variantes :

- la température est également prise en compte pour la détermination par l'opérateur des valeurs de seuil de tension Vt1, Vt2, Vt3, des courants de décharge Id et de charge Ic, et des paramètres électriques de seuil lors du paramétrage des étapes d'évaluation E1, E2, E3, E4 ;
- la température est un paramètre intégré à l'équation permettant de calculer la tension de sortie VO du modèle électrique équivalent 20 de la batterie 2 ;
- le système de diagnostic comprend ou communique avec un dispositif de mesure de température mesure la température de la batterie. Le dispositif de mesure de température peut être également celui servant à la mesure de tension, notamment si un système de gestion de batterie est utilisé.

Pour une variante de réalisation de l'invention, le logiciel 14 est capable d'adapter les valeurs des valeurs de seuil

de tension Vt1, Vt2, Vt3, des courants de décharge Id et de charge Ic, et des paramètres électriques de seuil selon la température mesurée,

Enfin, dans des variantes de réalisation, le système de diagnostic 1 est connecté à un système d'impression non couvert par l'invention qui imprime à chaque fois que le procédé de diagnostic P s'achève un bon d'impression à code-barres pouvant être apposé sur la batterie diagnostiquée et indiquant le résultat du diagnostic, « APTE » ou « INAPTE ».

## Revendications

1. Procédé de diagnostic (P) pour évaluer une aptitude d'une batterie (2) de type plomb-acide à être régénérée, ledit procédé de diagnostic (P) étant exécuté par un système de diagnostic (1) connecté électriquement à la batterie (2), et comprenant au moins :

   - une première étape d'évaluation (E1) durant laquelle le système de diagnostic (1) mesure une tension encircuit ouvert (VCO) de la batterie (2) puis la compare à une première valeur de seuil de tension (Vt1) ;
   - une seconde étape d'évaluation (E2) mise en œuvre si la tension en circuit ouvert (VCO) est supérieure à la première valeur de seuil de tension (Vt1), et durant laquelle le système de diagnostic (1) envoie à la batterie (2) un courant de décharge (Id) durant une durée, de décharge (td) prédéterminée et mesure simultanément une variation de tension de la batterie durant la durée de décharge (td), dite variation de tension en décharge ($\Delta$Vd), ladite variation de tension en décharge ($\Delta$Vd) étant comparée à une seconde valeur de seuil de tension (Vt2) ; et si la variation de tension en décharge ($\Delta$Vd) est supérieure à la seconde valeur de seuil de tension (Vt2), alors la batterie (2) est considérée comme inapte pour être régénérée ;
   - une troisième étape d'évaluation (E3) mise en œuvre lorsque la variation de tension en décharge ($\Delta$Vd) est inférieure à la seconde valeur de seuil de tension (Vt2), durant laquelle le système de diagnostic (1) identifie, au cours d'une sous-étape d'identification et à partir de la variation de tension en décharge ($\Delta$Vd), plusieurs paramètres électriques représentatifs de la batterie (2), qu'il compare ensuite, au cours d'une sous-étape de comparaison, respectivement à plusieurs paramètres électriques de seuil respectifs, le système de diagnostic (1) établissant que la batterie (2) est inapte pour être régénérée lorsque l'un des paramètres électriques parmi les plusieurs paramètres électriques n'est pas conforme au paramètre électrique de seuil qui lui est associé parmi les plusieurs paramètres électriques de seuil, et potentiellement apte à être régénérée autrement ; et
   - une quatrième étape d'évaluation (E4) mise en œuvre si la batterie (2) est considérée comme potentiellement apte à être régénérée suite à la troisième étape d'évaluation (E3), durant laquelle le système de diagnostic (1) envoie à la batterie (2) un courant de charge (Ic) durant une durée de charge (tc) prédéterminée et mesure simultanément une variation de tension de la batterie durant la durée de charge, dite variation de tension en charge ($\Delta$Vc); ladite variation de tension en charge ($\Delta$Vc) étant comparée à une troisième valeur de seuil de tension (Vt3) ;

   la batterie (2) étant considérée comme apte à être régénérée si la variation de tension en charge ($\Delta$Vc) est supérieure à la troisième valeur de seuil de tension (Vt3).

2. Procédé de diagnostic selon la revendication 1, dans lequel les plusieurs paramètres électriques sont identifiés durant la sous-étape d'identification en corrélant la variation de tension en décharge ($\Delta$Vd) à une tension de sortie (VO) d'un modèle électrique équivalent (20) modélisé dans le système de diagnostic (1) et représentatif de la batterie (2), lequel modèle électrique équivalent (20) étant simulé avec le courant de décharge (Id) durant une durée de simulation égale à la durée de décharge (td).

3. Procédé de diagnostic (P) selon la revendication 1 ou 2, dans lequel les plusieurs paramètres électriques comprennent une résistance de chute ohmique (R0), une résistance de transfert de charge (R1), une résistance de diffusion (R2), une capacitance de transfert de charge (C1), et une capacitance de diffusion (C2) ; et les plusieurs paramètres électriques de seuil comprennent une résistance de chute ohmique de seuil (R0t), une résistance de transfert de charge de seuil (R1t), une résistance de diffusion de seuil (R2t), une capacitance de transfert de charge de seuil (C1t), et une capacitance de diffusion de seuil (C2t).

4. Procédé de diagnostic (P) selon les revendications 2 et 3, dans lequel le modèle électrique équivalent (20) comprend un générateur d'entrée (G) délivrant une tension d'entrée correspondant à la tension en circuit ouvert (VCO), ainsi que plusieurs paramètres électriques équivalents incluant une résistance de diffusion équivalente (R2eq), une capacitance de diffusion équivalente (C2eq), une résistance de transfert de charge équivalente (R1eq), une capacitance de transfert de charge équivalente (C1eq), et une résistance de chute ohmique équivalente (R0eq) tels que :

- un premier bloc, comprenant la résistance de diffusion équivalente (R2eq) mise en parallèle avec la capacitance de diffusion équivalente (C2eq), est mis en série en sortie du générateur d'entrée (G),
- un second bloc, comprenant la résistance de transfert de charge équivalente (R1eq) mise en parallèle avec la capacitance de transfert de charge équivalente (C1eq), est mis en série en sortie du premier bloc, et
- la résistance de chute ohmique équivalente (R0eq) est mise en série en sortie du second bloc.

**5.** Procédé de diagnostic (P) selon la revendication 4, dans lequel, lors de la sous-étape d'identification, est mise en œuvre une analyse paramétrique en faisant varier les paramètres électriques équivalents jusqu'à corréler substantiellement la tension de sortie (VO) du modèle électrique équivalent (20) avec la variation de tension en décharge ($\Delta$Vd), et en déduire une valeur de chacun des plusieurs paramètres électriques comme étant équivalente au paramètre électrique équivalent qui lui est associé.

**6.** Procédé de diagnostic (P) selon l'une quelconque des revendications précédentes, dans lequel la troisième valeur de seuil de tension (Vt3) est inférieure ou égale à 500 mV, et par exemple inférieure ou égale à 300 mV.

**7.** Procédé de diagnostic (P) selon l'une quelconque des revendications précédentes, dans lequel le courant de charge (Ic) est un courant de charge continu ayant une intensité égale à 2A, à plus ou moins 10 % près, et la durée de charge (tc) est comprise entre 1 et 10 secondes.

**8.** Procédé de diagnostic (P) selon l'une quelconque des revendications précédentes, dans lequel la première valeur de seuil de tension (Vt1) est égale à 10,8 V, à plus ou moins 10% près, et la seconde valeur de seuil de tension (Vt2) est égale à 1V, à plus ou moins 10% près.

**9.** Procédé de diagnostic (P) selon l'une quelconque des revendications précédentes, dans lequel le courant de décharge (Id) est un courant de décharge continu ayant une intensité égale à 2A, à plus ou moins 10 % près, et la durée de décharge (td) est comprise entre 1 et 10 secondes.

**10.** Procédé de diagnostic (P) selon l'une quelconque des revendications précédentes, dans lequel le système de diagnostic (1) est connecté électriquement à la batterie (2) au moyen d'une première pince (111) et d'une seconde pince (112) reliées respectivement à un pôle positif (21) et un pôle négatif (22) de ladite batterie (2).

**11.** Procédé de diagnostic (P) selon l'une quelconque des revendications précédentes, dans lequel le système de diagnostic (1) est connecté à ou comprend au moins un dispositif de mesure de tension (3) pour mesurer au moins la tension en circuit ouvert (VCO) et la variation de tension en décharge ($\Delta$Vd).

**12.** Procédé de diagnostic (P) selon l'une quelconque des revendications précédentes, dans lequel le système de diagnostic (1) est connecté à ou comprend un dispositif de mesure de température conformé pour mesurer une température de la batterie (2) au moins au cours de la première étape d'évaluation (E1) et de la seconde étape d'évaluation (E2).

**13.** Système de diagnostic (1) pour évaluer une aptitude d'une batterie (2) de type plomb-acide à être régénérée, ledit système de diagnostic (1) comprenant une unité de contrôle (11) conformée pour la mise en œuvre des étapes d'évaluation (E1, E2, E3, E4) du procédé de diagnostic (P) selon l'une quelconque des revendications précédentes.

## Patentansprüche

**1.** Diagnoseverfahren (P) zur Beurteilung einer Regenerierbarkeit einer Batterie (2) vom Blei-Säure-Typ, wobei das Diagnoseverfahren (P) von einem Diagnosesystem (1) ausgeführt wird, das elektrisch mit der Batterie (2) verbunden ist, und mindestens umfasst:

- einen ersten Beurteilungsschritt (E1), bei dem das Diagnosesystem (1) eine Leerlaufspannung (VCO) der Batterie (2) misst und diese dann mit einem ersten Spannungsschwellenwert (Vt1) vergleicht;
- einen zweiten Beurteilungsschritt (E2), der umgesetzt wird, wenn die Leerlaufspannung (VCO) höher als der erste Spannungsschwellenwert (Vt1) ist, und bei dem das Diagnosesystem (1) der Batterie (2) einen Entladestrom (Id) während einer vordefinierten Entladezeit (td) zuführt und gleichzeitig eine Spannungsänderung der Batterie während der Entladezeit (td) misst, die als Spannungsänderung beim Entladen ($\Delta$Vd) bezeichnet wird, wobei die Spannungsänderung beim Entladen ($\Delta$Vd) mit einem zweiten Spannungsschwellenwert (Vt2)

verglichen wird;
und wenn die Spannungsänderung beim Entladen (ΔVd) den zweiten Spannungsschwellenwert (Vt2) überschreitet, die Batterie (2) als nicht regenerierbar betrachtet wird;
- einen dritten Beurteilungsschritt (E3), der umgesetzt wird, wenn die Spannungsänderung beim Entladen (ΔVd) niedriger als der zweite Spannungsschwellenwert (Vt2) ist, bei dem das Diagnosesystem (1) bei einem Identifizierungs-Teilschritt und basierend auf der Spannungsänderung beim Entladen (ΔVd) mehrere elektrische Parameter, die für die Batterie (2) repräsentativ sind, identifiziert, die es dann bei einem Vergleichs-Teilschritt jeweils mit mehreren entsprechenden elektrischen Schwellenwertparametern vergleicht, wobei das Diagnosesystem (1) ermittelt, dass die Batterie (2) nicht regenerierbar ist, wenn einer der elektrischen Parameter von den mehreren elektrischen Parametern nicht mit dem ihm von den mehreren Schwellenwertparametern zugeordneten Schwellenwertparametern übereinstimmt, und anderweitig potenziell regenerierbar ist; und
- einen vierten Beurteilungsschritt (E4), der umgesetzt wird, wenn die Batterie (2) nach dem dritten Beurteilungsschritt (E3) als potenziell regenerierbar betrachtet wird, bei dem das Diagnosesystem (1) der Batterie (2) einen Ladestrom (Ic) während einer vorgegebenen Ladezeit (tc) zuführt und gleichzeitig eine Spannungsänderung der Batterie während der Ladezeit, die als Spannungsänderung beim Laden (ΔVc) bezeichnet wird, misst, wobei die Spannungsänderung beim Laden (ΔVc) mit einem dritten Spannungsschwellenwert (Vt3) verglichen wird;

wobei die Batterie (2) als regenerierbar betrachtet wird, wenn die Spannungsänderung beim Laden (ΔVc) größer als der dritte Spannungsschwellenwert (Vt3) ist.

2. Diagnoseverfahren nach Anspruch 1, wobei die mehreren elektrischen Parameter bei dem Identifizierungs-Teilschritt identifiziert werden, indem die Spannungsänderung beim Entladen (ΔVd) mit einer Ausgangsspannung (VO) eines äquivalenten elektrischen Modells (20), das im Diagnosesystem (1) modelliert ist und für die Batterie (2) repräsentativ ist, korreliert wird, wobei das äquivalente elektrische Modell (20) mit dem Entladestrom (Id) während einer Simulationszeit simuliert wird, die der Entladezeit (td) entspricht.

3. Diagnoseverfahren (P) nach Anspruch 1 oder 2, wobei die mehreren elektrischen Parameter einen ohmschen Abfallwiderstand (R0), einen Lastübertragungswiderstand (R1), einen Streuwiderstand (R2), eine Lastübertragungskapazität (C1) und eine Streukapazität (C2) umfassen; und die mehreren elektrischen Schwellenparameter einen ohmschen Schwellwert-Abfallwiderstand (R0t), einen Schwellenwert-Lastübertragungswiderstand (R1t), einen Schwellenwert-Streuwiderstand (R2t), eine Schwellenwert-Lastübertragungskapazität (C1t) und eine Schwellenwert-Streukapazität (C2t) umfassen.

4. Diagnoseverfahren (P) nach den Ansprüchen 2 und 3, wobei das äquivalente elektrische Modell (20) einen Eingangsgenerator (G), der eine Eingangsspannung liefert, die der Leerlaufspannung (VCO) entspricht, sowie mehrere äquivalente elektrische Parameter, einschließlich eines äquivalenten Streuwiderstands (R2eq), einer äquivalenten Streukapazität (C2eq), eines äquivalenten Lastübertragungswiderstands (R1eq), einer äquivalenten Lastübertragungskapazität (C1eq) und eines äquivalenten ohmschen Abfallwiderstands (R0eq) umfasst, so dass:

- ein erster Block, der den äquivalenten Streuwiderstand (R2eq) umfasst, der mit der äquivalenten Streukapazität (C2eq) parallel geschaltet ist, am Ausgang des Eingangsgenerators (G) in Reihe geschaltet ist,
- ein zweiter Block, der den äquivalenten Lastübertragungswiderstand (R1eq) umfasst, der mit der äquivalenten Lastübertragungskapazität (C1eq) parallel geschaltet ist, am Ausgang des ersten Blocks in Reihe geschaltet ist, und
- der äquivalente ohmsche Abfallwiderstand (R0eq) am Ausgang des zweiten Blocks in Reihe geschaltet ist.

5. Diagnoseverfahren (P) nach Anspruch 4, wobei bei dem Identifizierungs-Teilschritt eine Parameteranalyse durchgeführt wird, indem die äquivalenten elektrischen Parameter geändert werden, bis die Ausgangsspannung (VO) des äquivalenten elektrischen Modells (20) substantiell mit der Spannungsänderung beim Entladen (ΔVd) korreliert, und indem davon ein Wert von jedem der mehreren elektrischen Parameter als äquivalent zu dem äquivalenten elektrischen Parameter abgeleitet wird, der ihm zugeordnet ist.

6. Diagnoseverfahren (P) nach einem der vorhergehenden Ansprüche, wobei der dritte Spannungsschwellenwert (Vt3) kleiner oder gleich 500 mV und beispielsweise kleiner oder gleich 300 mV ist.

7. Diagnoseverfahren (P) nach einem der vorhergehenden Ansprüche, wobei der Ladestrom (Ic) ein Gleichstrom-Ladestrom mit einer Stromstärke von gleich 2 A, plus oder minus zirka 10 %, ist und die Ladezeit (tc) zwischen 1 und 10 Sekunden beträgt.

8. Diagnoseverfahren (P) nach einem der vorhergehenden Ansprüche, wobei der erste Spannungsschwellenwert (Vt1) gleich 10,8 V, plus oder minus zirka 10 %, ist und der zweite Spannungsschwellenwert (Vt2) gleich 1 V, plus oder minus zirka 10 %, ist.

9. Diagnoseverfahren (P) nach einem der vorhergehenden Ansprüche, wobei der Entladestrom (Id) ein Gleichstrom-Ladestrom mit einer Stromstärke von 2 A, plus oder minus zirka 10 %, ist und die Entladezeit (td) zwischen 1 und 10 Sekunden beträgt.

10. Diagnoseverfahren (P) nach einem der vorhergehenden Ansprüche, wobei das Diagnosesystem (1) mittels einer ersten Klemme (111) und einer zweiten Klemme (112), die jeweils mit einem Pluspol (21) und einem Minuspol (22) der Batterie (2) verbunden sind, mit der Batterie (2) elektrisch verbunden ist.

11. Diagnoseverfahren (P) nach einem der vorhergehenden Ansprüche, wobei das Diagnosesystem (1) mit mindestens einer Spannungsmessvorrichtung (3) verbunden ist oder dieses umfasst, um mindestens die Leerlaufspannung (VCO) und die Spannungsänderung beim Entladen (ΔVd) zu messen.

12. Diagnoseverfahren (P) nach einem der vorhergehenden Ansprüche, wobei das Diagnosesystem (1) mit einer Temperaturmessvorrichtung verbunden ist oder diese umfasst, die ausgebildet ist, um mindestens bei dem ersten Beurteilungsschritt (E1) und dem zweiten Beurteilungsschritt (E2) eine Temperatur der Batterie (2) zu messen.

13. Diagnosesystem (1) zur Beurteilung einer Regenerierbarkeit einer Batterie (2) vom Blei-Säure-Typ, wobei das Diagnosesystem (1) eine Steuereinheit (11) umfasst, die für die Durchführung der Beurteilungsschritte (E1, E2, E3, E4) des Diagnoseverfahrens (P) nach einem der vorhergehenden Ansprüche ausgebildet ist.

## Claims

1. A diagnostic method (P) for assessing an ability of a lead-acid type battery (2) to be regenerated, said diagnostic method (P) being executed by a diagnostic system (1) electrically connected to the battery (2), and comprising at least:

- a first assessment step (E1) during which the diagnostic system (1) measures an open-circuit voltage (VCO) of the battery (2) and then compares it with a first voltage threshold value (Vt1);
- a second assessment step (E2) implemented if the open-circuit voltage (VCO) is higher than the first voltage threshold value (Vt1), and during which the diagnostic system (1) sends to the battery (2) a discharge current (Id) during a predetermined discharge duration (td) and simultaneously measures a voltage variation of the battery during the discharge duration (td), so-called the discharge voltage variation (ΔVd), said discharge voltage variation (ΔVd) being compared with a second voltage threshold value (Vt2);
and if the discharge voltage variation (ΔVd) is higher than the second voltage threshold value (Vt2), then the battery (2) is considered incapable of being regenerated;
- a third assessment step (E3) implemented when the discharge voltage variation (ΔVd) is lower than the second voltage threshold value (Vt2), during which the diagnostic system (1) identifies, during an identification sub-step and from the discharge voltage variation (ΔVd), several electrical parameters representative of the battery (2), which it then compares, during a comparison sub-step, respectively with several respective threshold electrical parameters, the diagnostic system (1) establishing that the battery (2) is uncapable of being regenerated when one of the electrical parameters among the several electrical parameters is not compliant with the threshold electrical parameter associated therewith among the several threshold electrical parameters, and potentially capable of being regenerated otherwise; and
- a fourth assessment step (E4) implemented if the battery (2) is considered potentially capable of being regenerated following the third assessment step (E3), during which the diagnostic system (1) sends to the battery (2) a charging current (Ic) during a predetermined charging duration (tc) and simultaneously measures a voltage variation of the battery during the charging duration, so-called the charging voltage variation (ΔVc), said charging voltage variation (ΔVc) being compared with a third voltage threshold value (Vt3);

the battery (2) being considered capable of being regenerated if the charging voltage variation (ΔVc) is higher than the third voltage threshold value (Vt3).

2. The diagnostic method according to claim 1, wherein the several electrical parameters are identified during the identification sub-step by correlating the discharge voltage variation (ΔVd) with an output voltage (VO) of an

equivalent electrical model (20) modeled in the diagnostic system (1) and representative of the battery (2), which equivalent electrical model (20) being simulated with the discharge current (Id) during a simulation duration equal to the discharge duration (td).

**3.** The diagnostic method (P) according to claim 1 or 2, wherein the several electrical parameters comprise an ohmic voltage drop resistance (R0), a charge transfer resistance (R1), a diffusion resistance (R2), a charge transfer capacitance (C1), and a diffusion capacitance (C2); and the several threshold electrical parameters comprise a threshold ohmic voltage drop resistance (R0t), a threshold charge transfer resistance (R1t), a threshold diffusion resistance (R2t), a threshold charge transfer capacitance (C1t), and a threshold diffusion capacitance (C2t).

**4.** The diagnostic method (P) according to claims 2 and 3, wherein the equivalent electrical model (20) comprises an input generator (G) supplying an input voltage corresponding to the open-circuit voltage (VCO), as well as several equivalent electrical parameters including an equivalent diffusion resistance (R2eq), an equivalent diffusion capacitance (C2eq), an equivalent charge transfer resistance (R1eq), an equivalent charge transfer capacitance (C1eq), and an equivalent ohmic voltage drop resistance (R0eq) such that:

- a first block, comprising the equivalent diffusion resistance (R2eq) set in parallel with the equivalent diffusion capacitance (C2eq), is set in series at the output of the input generator (G),
- a second block, comprising the equivalent charge transfer resistance (R1eq) set in parallel with the equivalent charge transfer capacitance (C1eq), is set in series at the output of the first block, and
- the equivalent ohmic voltage drop resistance (R0eq) is set in series at the output of the second block.

**5.** The diagnostic method (P) according to claim 4, wherein, during the identification sub-step, a parametric analysis is performed by varying the equivalent electrical parameters until substantially correlating the output voltage (VO) of the equivalent electrical model (20) with the discharge voltage variation ($\Delta$Vd), and by deducing a value of each of the several electrical parameters as being equivalent to the equivalent electrical parameter associated therewith.

**6.** The diagnostic method (P) according to any one of the preceding claims, wherein the third voltage threshold value (Vt3) is lower than or equal to 500 mV, and for example lower than or equal to 300 mV.

**7.** The diagnostic method (P) according to any one of the preceding claims, wherein the charging current (Ic) is a DC charging current having an intensity equal to 2 A, within a 10% margin, and the charging duration (tc) is comprised between 1 and 10 seconds.

**8.** The diagnostic method (P) according to any one of the preceding claims, wherein the first voltage threshold value (Vt1) is equal to 10.8 V, within a 10% margin, and the second voltage threshold value (Vt2) is equal to 1 V, within a 10% margin.

**9.** The diagnostic method (P) according to any one of the preceding claims, wherein the discharge current (Id) is a DC discharge current having an intensity equal to 2 A, within a 10% margin, and the discharge duration (td) is comprised between 1 and 10 seconds.

**10.** The diagnostic method (P) according to any one of the preceding claims, wherein the diagnostic system (1) is electrically connected to the battery (2) by means of a first clamp (111) and a second clamp (112) respectively connected to a positive pole (21) and a negative pole (22) of said battery (2).

**11.** The diagnostic method (P) according to any one of the preceding claims, wherein the diagnostic system (1) is connected to, or comprises, at least one voltage measuring device (3) for measuring at least the open-circuit voltage (VCO) and the discharge voltage variation ($\Delta$Vd).

**12.** The diagnostic method (P) according to any one of the preceding claims, wherein the diagnostic system (1) is connected to, or comprises, a temperature measuring device arranged to measure a temperature of the battery (2) at least during the first assessment step (E1) and the second assessment step (E2).

**13.** A diagnostic system (1) for assessing an ability of a lead-acid type battery (2) to be regenerated, said diagnostic system (1) comprising a control unit (11) arranged to implement the steps of assessing (E1, E2, E3, E4) the diagnostic method (P) according to any one of the preceding claims.

Fig. 1

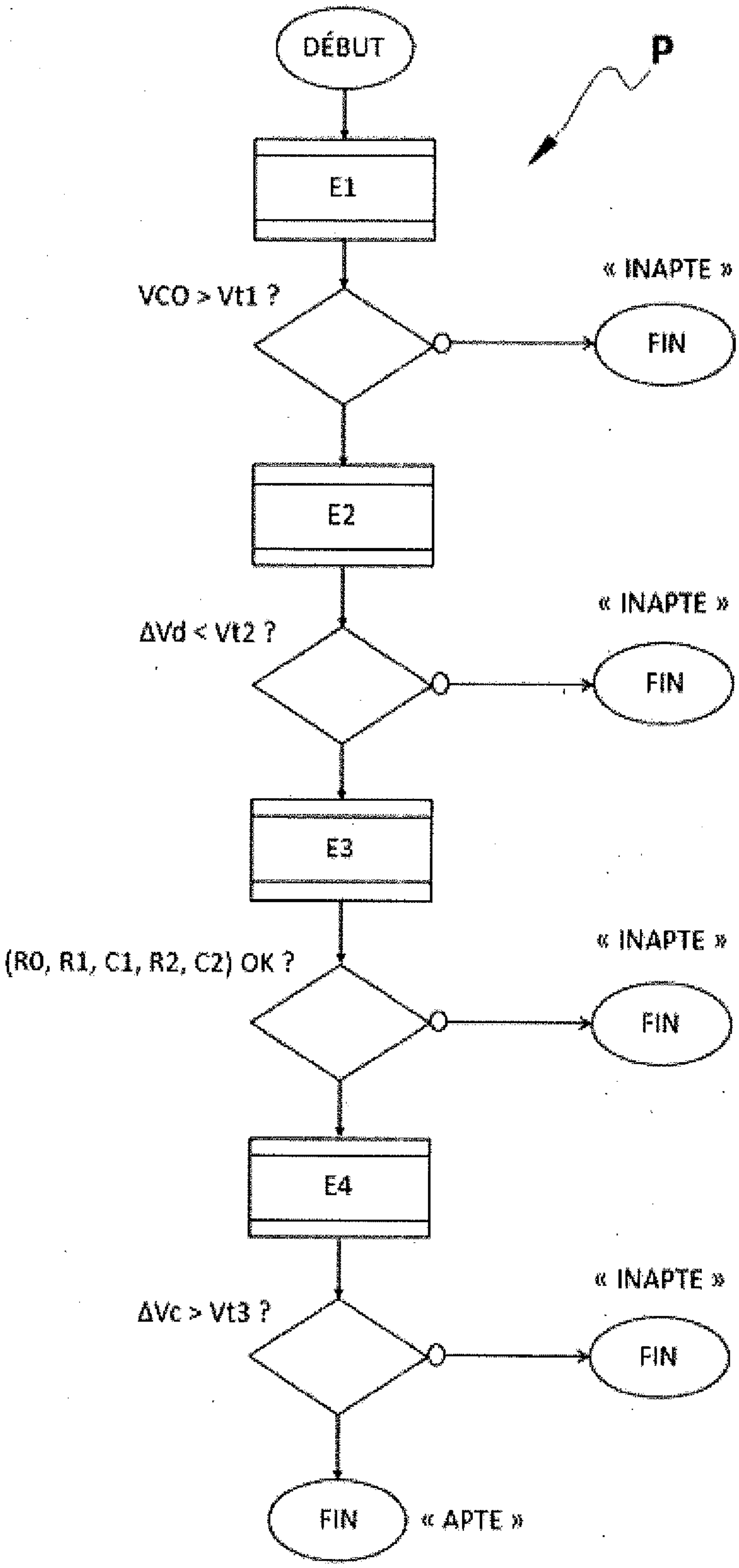
DÉBUT
P
E1
VCO > Vt1 ?
« INAPTE »
FIN
E2
ΔVd < Vt2 ?
« INAPTE »
FIN
E3
(R0, R1, C1, R2, C2) OK ?
« INAPTE »
FIN
E4
ΔVc > Vt3 ?
« INAPTE »
FIN
FIN
« APTE »

Fig. 2

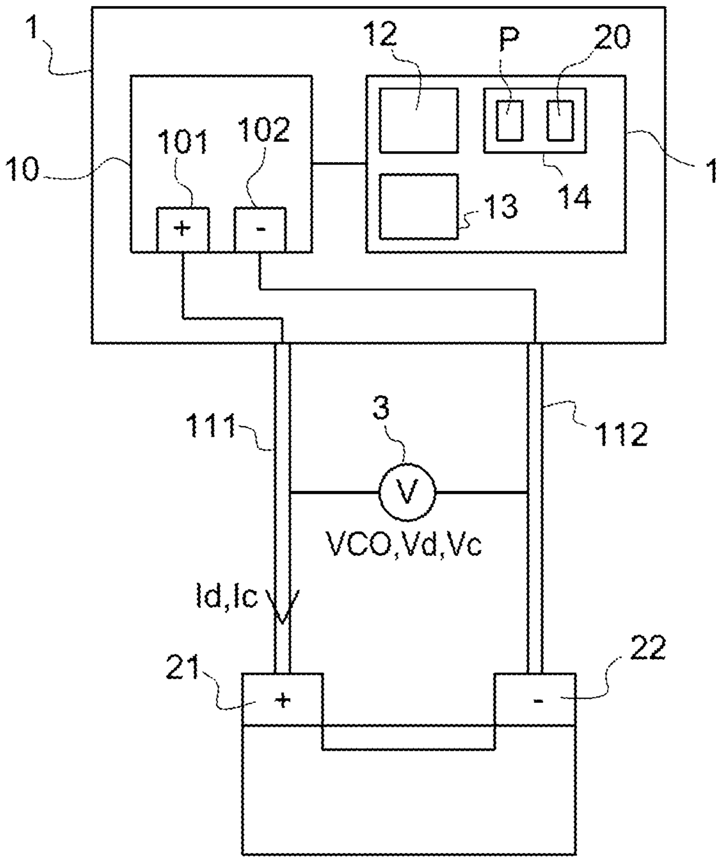
1
12
P
20
10
101
102
11
13
14
+
-
3
111
112
V
VCO,Vd,Vc
Id,Ic
21
22
+
-

Fig. 3

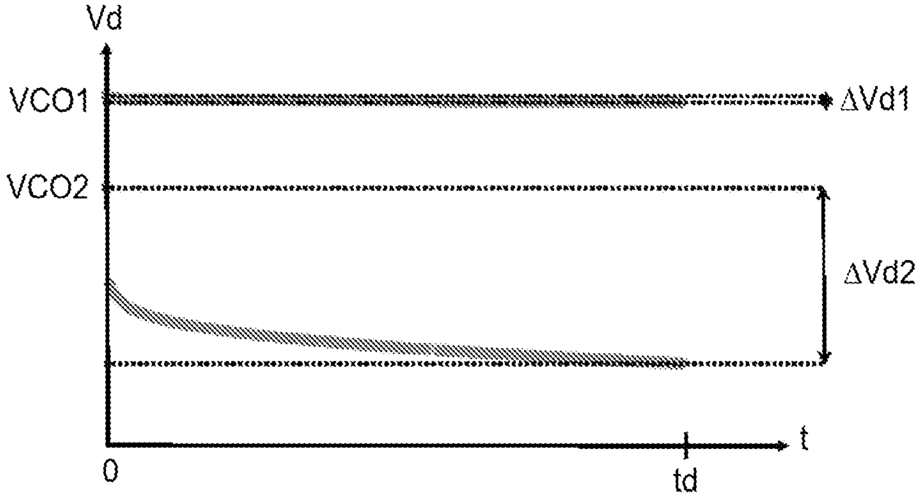
Vd
VCO1
VCO2
ΔVd1
ΔVd2
0
td
t

**Fig. 4**

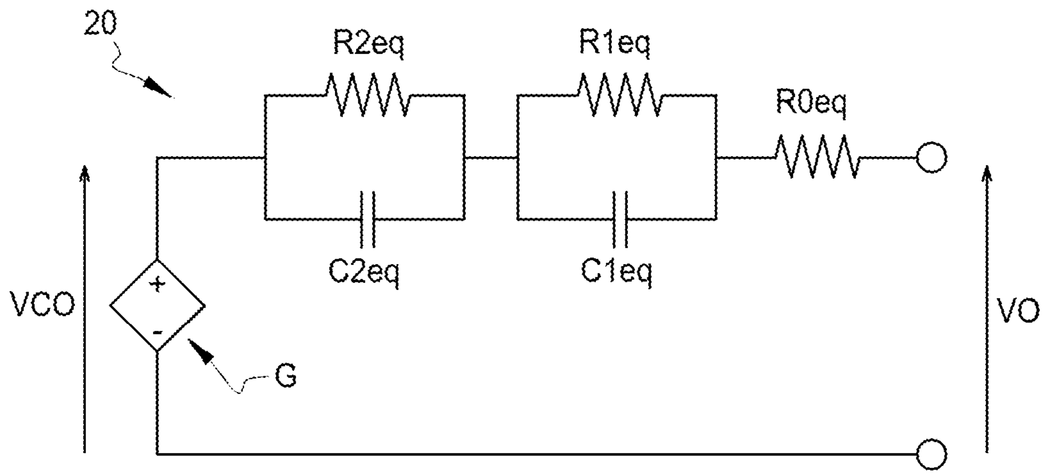


**Fig. 5**

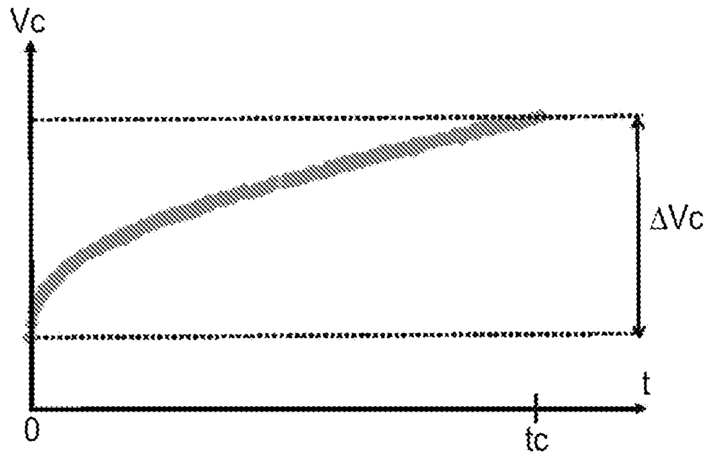

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 6259254 B1
- US 6369577 B1
- EP 2947471 A1